(19) Europäisches Patentamt / European Patent Office / Office européen des brevets

(11) **EP 2 075 910 A1**

(12) **EUROPEAN PATENT APPLICATION**

(43) Date of publication:
**01.07.2009 Bulletin 2009/27**

(51) Int Cl.:
*H03F 3/45* (2006.01)　　　*H03F 1/30* (2006.01)

(21) Application number: **07025219.2**

(22) Date of filing: **28.12.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Varian B.V.**
**4330 Middelburg (NL)**

(72) Inventor: **van den Heuvel, Nils**
**3815 AE Amersfoort (NL)**

(74) Representative: **Mollekopf, Gerd Willi**
**Kahler Käck Mollekopf,**
**Vorderer Anger 239**
**86899 Landsberg a. Lech (DE)**

Remarks:
Amended claims in accordance with Rule 137(2) EPC.

(54) **Instrumentation amplification with input offset adjustment**

(57) In a single-ended or differential instrument amplifier (306), an input offset may be adjusted by driving current ($I_{Offset}$) into the impedance (314, 316) of a feedback network (308) of the amplifier. The amplifier may be provided with programmable gain capability. The impedance does not change with different gain settings, such that the input offset adjustment is equal for all gains. The amplifier may receive the output (302) of a sensor such as, for example, a gas detector such as a thermal conductivity detector. The gas detector may be utilized to measure a gas flowing from a gas source such as, for example, a chromatographic column.

Figure 3

**Description**

## FIELD OF THE INVENTION

This invention generally relates to electrical signal amplifiers and associated instrumentation. More particularly, the invention relates to signal amplifiers in which the adjustment of input offset is desirable. Such signal amplifiers may receive an output of a sensor, detector or transducer in an analytical or measuring instrument, with an undesired sensor offset being associated with the output.

## BACKGROUND OF THE INVENTION

Electronic instruments typically employ a sensor (or detector, transducer, etc.) to detect or measure a particular physical parameter or stimulus (e.g., sound, temperature, weight, force, pressure, thermal conductivity, etc.) and to convert the physical parameter to an electrical signal indicative of a value of the physical parameter. Sensors typically generate rather low electrical signals that are typically amplified in an input stage of the instrument. An input stage amplifier is typically characterized by a gain, $G = \dfrac{V_{out}}{V_{in}}$ , where $V_{out} > V_{in}$. Amplifiers are also typically powered by a DC power supply that provides both a positive and a negative bias, VDC and V-DC. Ideally, when a sensor does not detect a signal indicative of the physical parameter to be measured, the input signal $V_{in}$ is zero, and the output signal $V_{out}$ is also zero. When an input signal is sensed it is amplified to generate the output signal $V_{out}$ in both the positive and negative directions. There is a maximum level to the signal output $V_{out}$. The DC positive and negative biases, VDC and V-DC, are the maximum signal levels (positive and negative) of the amplifier output $V_{out}$.

One problem with many sensors is that they are not ideal and tend to generate some signal level in operation even without any stimulus from the physical parameter they are intended to measure. This is known as a sensor offset. In a thermal conductivity detector, the sensor offset may be caused by mismatches in the nominal resistances of the sensing elements (filaments, wires, etc.). A sensor offset at the input stage amplifier is amplified and produces a non-zero signal output, $V_{out}$. The effect is to reduce the available output range of the amplifier. With a sensor output, the maximum input signal that may be detected is a signal level plus sensor offset that generates the signal output, $V_{out} =$ VDC or V-DC. Thus, to allow for large amplification and maintain the full output range of the amplifier, it is desirable to provide an input offset adjustment.

Amplifiers may advantageously be provided with a programmable gain. A programmable gain allows the user to select a gain that is optimal for the signal being generated by the sensor. A user may want to focus on a selected range of input signal levels. By selecting an appropriate gain, the user may obtain meaningful output signal levels through the entire output range of the amplifier. A programmable gain does not, however, account for the sensor offset. Once the desired gain is set, the user may still need to account for the sensor offset.

A thermal conductivity detector (TCD) is an example of a sensor commonly employed to measure changes in the thermal conductivity of a gas stream and thus is useful in a variety of applications such as, for example, gas chromatography (GC). A TCD may include a four-element bridge circuit, often arranged as a Wheatstone bridge, in which the elements are temperature-sensitive (thermal-sensing) elements such as resistive filaments or semiconducting thermistors (generally, resistors). The resistances of the sensing elements vary in response to temperature changes. The temperature of each sensing element in turn depends on the thermal conductivity of the gas flowing around the sensing element. At least one resistor (or one pair of resistors) may serve as a sample resistor, and at least one resistor (or one pair of resistors) may serve as a reference resistor. In a GC application, a reference voltage is sensed at both the sample and reference resistors in the presence of the carrier (reference) gas (e.g., hydrogen, helium, etc.), and a sample voltage is sensed at the sample resistor(s) in the presence of the GC column effluent containing both the carrier gas and analyte molecules (peaks). As the sample gas is introduced, a temperature change is sensed by the sample resistors and the resulting change in resistance causes a change in the signal level at the sample resistors. This change in the signal level may be correlated to the temperature change and further with the concentration of the sample gas. The TCD may be arranged such that the effect of thermal conductivity of the carrier gas is canceled, and may be structured such that other effects such as variations in flow rate, pressure and electrical power are minimized.

TCDs are also subject to sensor offset. One source of sensor offset in a TCD may be caused by mismatches in the nominal resistances of the sensing elements (filaments, wires, etc.). Known technology has not adequately addressed this type of sensor offset.

In view of the foregoing, there is a need for an amplifier circuit and a method that provide signal amplification and input offset adjustment, including in amplifiers capable of programmable gain.

## SUMMARY OF THE INVENTION

The invention is defined in claims 1 and 17, respectively.

Particular embodiments are set out in the dependent claims.

According to the invention, an amplifier circuit includes an amplifier including a non-inverting input, an inverting input, and an amplifier output, a feedback network in signal communication with the amplifier output and the inverting input, and a current source in signal communication with the inverting input. The current source is adjustable to a plurality of selectable input offsets to generate a plurality of corresponding voltage offsets at the inverting input.

According to an embodiment, the feedback network is adjustable to a plurality of gain settings of the amplifier circuit. The feedback network is configured such that the impedance at the inverting input is equal for all gain settings, whereby the plurality of selectable input offsets and the plurality of corresponding voltage offsets are independent of the plurality of gain settings.

According to an embodiment, the amplifier circuit includes a first amplifier, a second amplifier, a feedback network, and a current source. The first amplifier includes a first non-inverting input, a first inverting input, and a first amplifier output. The second amplifier includes a second non-inverting input, a second inverting input, and a second amplifier output. The feedback network is in signal communication with the first amplifier output, the first inverting input, the second amplifier output, and the second inverting input. The current source is in signal communication with the inverting input. The current source is adjustable to a plurality of selectable input offsets to generate a plurality of corresponding voltage offsets at the inverting input.

According to an embodiment, the feedback network is adjustable to a plurality of gain settings of the amplifier circuit. The feedback network is configured such that the impedance between the first and second inverting inputs is equal for all gain settings, whereby the plurality of selectable input offsets and the plurality of corresponding voltage offsets are independent of the plurality of gain settings.

According to an embodiment, the current source includes a first current source in signal communication with the first inverting input, and a second current source in signal communication with the first inverting input and with the second inverting input. At least one of the first and second current sources is adjustable to the plurality of selectable input offsets to generate a plurality of corresponding voltage offsets at the first and second inverting inputs.

According to an embodiment, an amplifier circuit further includes a device or circuitry for adjusting the feedback network to a plurality of gain settings of the amplifier circuit. The impedance at the inverting input is equal for all gain settings, whereby the plurality of selectable input offsets and the plurality of corresponding voltage offsets are independent of the plurality of gain settings.

According to an embodiment, the amplifier circuit includes an amplifier including a non-inverting input, an inverting input, and an amplifier output, a feedback network in signal communication with the output and the inverting input, and a device or circuitry for driving an adjustable current into the inverting input. The adjustable current is adjustable to a plurality of selectable input offsets to generate a plurality of corresponding voltage offsets at the inverting input.

According to an embodiment, in the amplifier circuit, at least one amplifier may be in signal communication with a gas detector. In some implementations, the gas detector may be in flow communication with a chromatographic column. In some implementations, the gas detector may be a thermal conductivity detector (TCD).

According to an embodiment, in the amplifier circuit, at least one amplifier may be in signal communication with a bridge output of a bridge circuit. The bridge circuit may include at least two temperature-sensitive resistive elements, one of the resistive elements communicating with a first gas source and the other resistive element communicating with a second gas source.

According to the invention, a method is provided for adjusting an input offset at an input of an amplifier circuit is provided. An input signal is amplified in a differential amplifier to generate an output signal. The output signal is fed back to an inverting input of the differential amplifier through a feedback network. An adjustable current is driven into the inverting input. The adjustable current is adjustable to a plurality of selectable input offsets to generate a plurality of corresponding voltage offsets at the inverting input.

According to an embodiment, the method further includes adjusting the feedback network to a selected one of a plurality of selectable gain settings of the amplifier circuit, wherein the impedance at the inverting input is equal for any gain setting selected, whereby adjustment of the current is independent of the selected gain setting.

According to an embodiment, the method further includes receiving an input signal at a non-inverting input of the differential amplifier from a gas detector. In some implementations, the input signal may be indicative of a concentration of a gas flowed from a chromatographic column. In some implementations, the gas detector may be a thermal conductivity detector

The above embodiments of the amplifier circuit and method can be combined in any way, i.e. two or more embodiments may form a further embodiment of the invention.

Other devices, apparatus, systems, methods, features and/or advantages of the invention will be or will become apparent to one with skill in the art upon examination of the following figures and detailed description. It is intended that all such additional devices, apparatus, devices, systems, methods, features and/or advantages be included within this description, be within the scope of the invention, and be protected by the accompanying claims.

## BRIEF DESCRIPTION OF THE DRAWINGS

The invention can be better understood by referring to the following figures. The components in the figures are not necessarily to scale, emphasis instead being placed upon illustrating the principles of the invention. In the figures, like reference numerals designate corresponding parts throughout the different views.

Figure 1    is a schematic view of an example of an analytical instrument or system in which implementations of the invention may be practiced.

Figure 2    is a schematic view of an example of a detector and amplifier with which implementations of the invention may be practiced.

Figure 3    is a schematic view of an example of a single-ended instrumentation amplifier circuit with input offset adjustment according to one implementation.

Figure 4    is a schematic view of an example of a differential instrumentation amplifier circuit with input offset adjustment according to another implementation.

Figure 5    is a schematic view of another example of a single-ended instrumentation amplifier circuit with input offset adjustment according to another implementation.

Figure 6    is a schematic view of another example of a differential instrumentation amplifier circuit with input offset adjustment according to another implementation.

Figure 7    is a schematic view of another example of a single-ended instrumentation amplifier circuit with input offset adjustment according to another implementation.

Figure 8    is a schematic view of another example of a differential instrumentation amplifier circuit with input offset adjustment consistent with the present invention.

## DETAILED DESCRIPTION OF THE INVENTION

In general, the term "communicate" (for example, a first component "communicates with" or "is in communication with" a second component) is used herein to indicate a structural, functional, mechanical, electrical, optical, magnetic, ionic or fluidic relationship between two or more components or elements. As such, the fact that one component is said to communicate with a second component is not intended to exclude the possibility that additional components may be present between, and/or operatively associated or engaged with, the first and second components.

In general, the phrase "in signal communication" refers to any means for passing and/or communicating a signal or information from a first device or component to a second device or component or to more than one other device or component. Examples of such means include, but are not limited to, connecting, electromagnetically coupling, transmitting and receiving wired or wirelessly, and passing after processing, filtering, converting, or modifying a signal or information.

In general, unless otherwise indicated or evident from the context, the term "impedance" or "impedance element" may refer to a resistance (or resistive) element such as a resistor, a capacitance (or capacitive) element such as a capacitor, an inductance (or inductive) element such as an inductor, combinations of more than one of the foregoing elements, combinations of one or more types of the foregoing elements, or devices or circuit portions exhibiting impedance. As appreciated by persons skilled in the art, resistors, capacitors, inductors, amplifiers, and the like may constitute one or more discrete components or portions of solid-state or integrated circuits (ICs).

The description below refers to thermal conductivity detectors (TCDs) as may be employed in gas chromatography as an example of a sensor that may be placed in signal communication with an input stage amplifier. By way of example, the TCD or other sensor may be employed in an instrument such as a gas chromatographic (GC) system. Despite the foregoing, persons skilled in the art will appreciate that examples consistent with the present invention may be utilized with any suitable sensor in any suitable application (weigh scales, pressure measurement, etc.). In addition, such sensors, including TCDs, may be powered by either direct current (DC) or alternating current (AC). In addition, implementations of the invention may be provided in discrete component form, in ICs, or in combination.

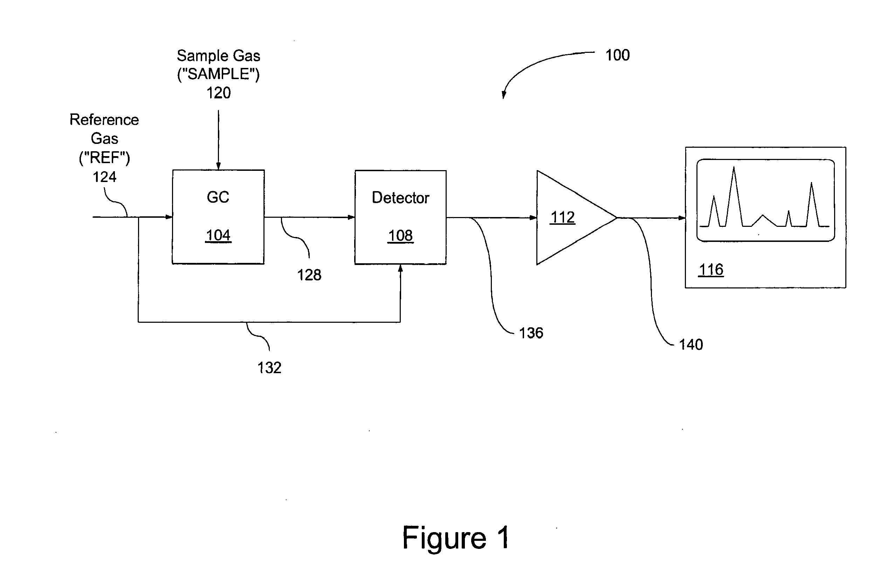

Figure 1 is a schematic diagram of an example of an operating environment or system in which implementations of the invention may be practiced. Figure 1 illustrates a gas chromatograph (GC) system **100** that may include a GC apparatus **104,** a detector **108,** a detector amplifier **112,** and a readout/display device **116.** Any type of GC apparatus **104** may be provided, the basic design and operating principles of which are known and need not be described in detail here. More generally, any apparatus providing a flow of gas to be analyzed may be provided, the illustrated GC apparatus **104** being but one example.

The detector **108** may be any suitable detector such as a thermal conductivity detector (TCD). An input **120** of sample gas and an input **124** of reference (carrier) gas are provided to the GC apparatus **104.** An injector (not shown) is typically employed to combine the sample gas and the carrier gas such that the carrier gas carries the components of the sample gas through a chromatographic column (not shown) of the GC apparatus **104.** The GC apparatus **104** may include an oven in which the column is located to heat the solute-carrier gas mixture flowing through the column, or alternatively (or additionally) may include a device or means for directly heating the column. The effluent (SAMPLE + REF) **128** from the GC column may be input into the detector **108.** Additionally, at some point ahead of the sample injector of the GC apparatus **104,** a portion **132** of the carrier (REF) gas flow may be diverted or split from the main carrier gas input **124** and directed separately to the detector **108.** The detector **108** produces an output (measurement) signal **136** indicative of the concentration of the sample gas as the peaks are eluted from the column, such as may be correlated from measured thermal conductivity in the case of a TCD. The detector amplifier **112** amplifies the measurement signal **136** and outputs an amplified signal **140.** The amplified signal **140** may be transmitted to additional signal conditioning and processing circuitry (not shown) as needed. The readout/display device **116** may be utilized to receive the amplified signal **140** and produce a chromatogram of peaks constituting user-interpretable results of the operation of the GC apparatus **104,** for example TCD output response as a function of time.

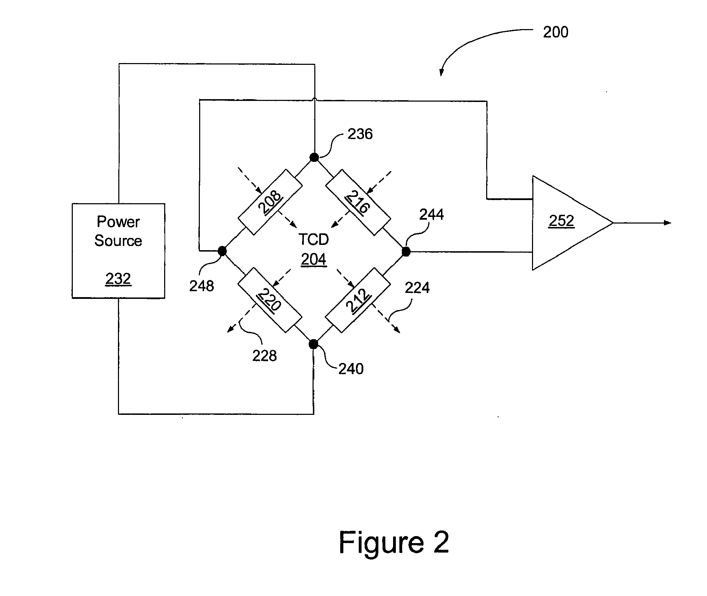

Figure 2 is a schematic diagram of an example of a detector or detector circuitry **200** such as may be utilized in an analytical instrument system such as the GC system **100** illustrated in Figure 1. The illustrated example is useful, for example, when the detector **200** is configured as a TCD. Accordingly, the detector **200** may include a sensor portion **204** arranged as a four-element bridge circuit housed in a suitable detector cell structure (not shown) in flow communication with a suitable gas source such as a GC apparatus. The legs or arms of the bridge circuit include an opposing pair of sample resistors **208** and **212** and an opposing pair of reference resistors **216** and **220.** One (or both) of the sample resistors **208** and **212** are exposed to a mixed flow **224** of sample and carrier gas, for example, the effluent from a GC column. One (or both) of the reference resistors **216** and **220** are exposed to a flow **228** of reference gas only, which is separate from the carrier-sample effluent flow **224.** As an example, the carrier gas employed for GC (e.g., helium, hydrogen, etc.) may serve as the reference gas. A power source **232** supplies an excitation voltage to input nodes **236** and **240** of the bridge circuit. One or both output nodes **244** and **248** may be connected in signal communication with a suitable instrument amplifier (IA) **252.**

In a typical operation, when each gas flow **224** and **228** contains only reference gas (e.g., before sample peaks are eluted from a GC column), the respective temperatures of the four resistors **208, 212, 216, 220** of the bridge circuit should be the same and at a known value for the reference gas. The bridge circuit should be balanced and produce an output at some zero-level or baseline level indicative of the absence of sample gas. The thermal conductivity of a gas stream is dependent on the chemical composition of the gas. In most cases, the thermal conductivities of sample gas components are appreciably lower than the thermal conductivity of the reference gas. Hence, when the gas flow **224** includes sample components, the resulting thermal conductivity of the mixed flow **224** is lower than the thermal conductivity of the reference-only flow **228.** Moreover, in the case of GC operation, the thermal conductivity of the mixed flow **224** changes relative to the thermal conductivity of the reference-only flow **228** as different peaks elute from the column. Consequently, the temperature(s) of the resistor(s) **208** and/or **224** in thermal contact with the mixed flow **224** change and likewise their resistance value(s) change, while the temperature(s) and resistance(s) of the resistor(s) **216** and/or **220** in thermal contact with the reference-only flow **228** remain constant. For example, the power source **232** and/or a separate heating device may be operated to initially heat the resistors **208, 212, 216, 220** to an equilibrium temperature, determined by the flow rate and thermal conductivity of the reference gas and the current through the resistors **208, 212, 216, 220,** after which time heat is carried away from the resistors **208, 212, 216, 220** by the flowing gases. Thus, the presence of sample components in the mixed flow **224** causes an imbalance in the bridge circuit, which typically represents the difference in thermal conductivity between the sample gas and the reference gas. This difference is reflected in the output level of the bridge circuit as a measurement signal, which is then amplified by the instrument amplifier **252.**

It will be noted that there are several ways to configure and power the bridge circuit illustrated in Figure 2, including the following four examples. First, in a constant voltage method, a constant voltage may be applied across the bridge circuit. Second, in a constant current method, a constant current may be applied to the bridge circuit. In either of these two cases, the output signal of the bridge circuit is a function of the voltage imbalance appearing at the midpoint of the bridge circuit. Third, in a constant-temperature method, the output signal of the bridge circuit is utilized as a feedback voltage control to maintain the bridge circuit in a balanced state. In this case, the heat required to keep the temperature of the bridge elements constant is measured, instead of measuring the increase in temperature resulting from sample components. Fourth, in a constant mean temperature method, the bridge circuit is connected within a second bridge circuit and feedback control, in which case the output signal is the voltage imbalance across the inner bridge. Implementations of the present invention may be configured to operate with all such types of the bridge circuits.

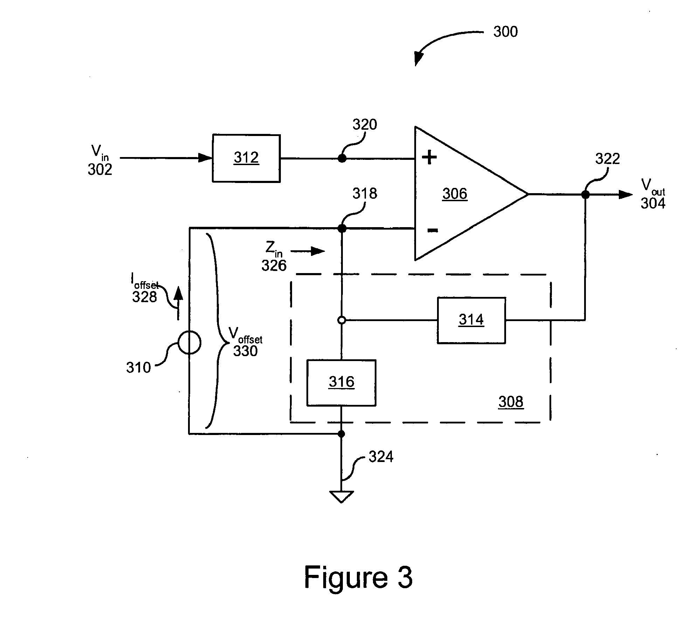

Figure 3 is a schematic diagram of an example of an amplifier circuit **300** consistent with the present invention. The amplifier circuit **300** receives an input signal **302** and produces a corresponding output signal **304.** The amplifier circuit **300** may include an amplifier element (generally referred to simply as an "amplifier") **306,** a feedback network **308,** a current source **310,** and a compensating impedance element **312.** The feedback network **308** may include a first feedback impedance element **314** and a second feedback impedance element **316.** In this example, the amplifier circuit **300** in Figure 3 is a single-ended (current) signal instrumentation amplifier. A sensor (not shown), such as a bridge circuit operating as a TCD, may be in signal communication with the amplifier circuit **300** so as to provide the input signal **302.** In one example, the input signal **302** may be indicative of changes in thermal conductivity of a sample gas being measured. For convenience, the ensuing description will refer to schematically illustrated impedance elements simply as "impedances."

In the example illustrated in Figure 3, the amplifier **306** in the amplifier circuit **300** is a differential amplifier having differential inputs, i.e., an inverting input **318** and a non-inverting input **320.** As such, the amplifier **306** may be considered as having a "programmable gain" in that it may be programmed by selecting a suitable impedance value for the second feedback impedance **316.** As an example, the amplifier **306** may be an operational amplifier generally known as an "op-amp."

Utilizing an op-amp for the amplifier **306,** the amplifier circuit **300** is in an inverting configuration where compensating impedance **312** is in signal communication with the non-inverting input **320** of the amplifier **306** and the feedback network **308** is in signal communication with both the output **322** of the amplifier **306** and the inverting input **318** of the amplifier **306.** The current source **310** is also in signal communication with the inverting input **318** of the amplifier **306.** In this example, the first impedance **314** is in signal communication with both the output **322** of the amplifier **306** and the inverting input **318** of the amplifier **306,** and the second impedance **316** is in signal communication with the inverting input **318** of the amplifier **306** and a signal ground **324.**

In this example, the current source **310** is in signal communication with the negative input node **318** to inject current into the input impedance $Z_{in}$ **326** of the feedback network **308** formed by the first and second feedback impedances **314** and **316.** The current injected by the current source **310** is a constant offset current, $I_{offset}$ **328,** which forms an offset voltage, $V_{offset}$ **330,** at the negative input node **318.** In the example shown, the first feedback impedance **314** may be set to a resistive value of *(g-1)\*R* where "*g*" is the gain of the amplifier **306,** and the second feedback impedance **316** may be set to a resistive value of *R* where *R* is a resistance selected to program the gain of the amplifier **306.** With these values for the first and second feedback impedances **314** and **316,** the offset voltage $V_{offset}$ **330** is:

$$V_{offset} = \left(R \parallel (g-1)R\right)I_{offset} ,$$

which can be restated as:

$$V_{offset} = \frac{(g-1)R}{g} I_{offset} .$$

The compensating impedance **312** may be inserted in series with the non-inverting input **320** of the amplifier element **340.** The value of the compensating impedance **312** may be, in general, the value of the impedance of the parallel combination of the first and second feedback impedances **314** and **316** (i.e., the input impedance $Z_{in}$ **326).** That is, the value of the compensating impedance **312** in the example described above may be equal to $\frac{(g-1)R}{g}$ .

The amplifier circuit **300** illustrated in Figure 3 provides a user with the ability to control the current source **310** to inject a desired offset current, $I_{offset}$ **328,** to create a $V_{offset}$ **330** that offsets the sensor offset contribution to the input signal **302.** The current source **310** simplifies the process of sensor offset compensation by providing the user with just one parameter to adjust: $I_{offset}$. In one example of using the amplifier circuit **300,** the user may set up a sensor to generate a 'zero' signal. The input offset adjustment may be controlled by the single-ended current input. A differential input or ground reference is not required. Thus, in setting the input offset adjustment, the user may configure a sensor to generate a signal that is selected to represent a zero level. In the case of a TCD employed with a GC, the sensor may be configured to provide a balanced signal level at the sensor output leads. That is, the sensor may be subjected to a temperature at which all of the resistor filaments should be of equal value. The user may then adjust the current source **310** to generate an $I_{offset}$ **328** that applies a $V_{offset}$ **330** at the inverting input **318** of the amplifier **306,** and which generates an output signal **304** having a signal value representative of a zero level of sample gas.

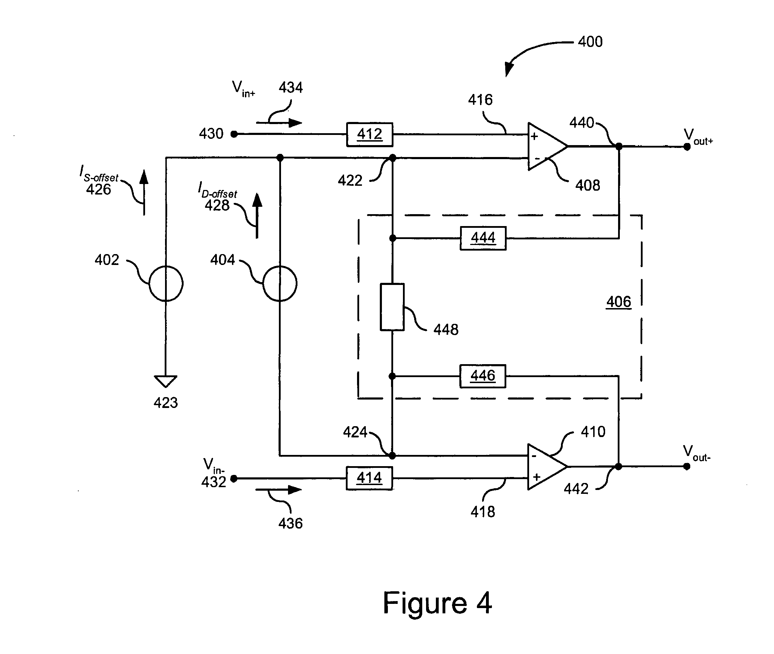

Figure 4 is a schematic diagram of an example of a differential instrumentation amplifier circuit **400** consistent with the present invention. The amplifier circuit **400** may include first and second current sources **402** and **404,** a feedback network **406,** a first amplifier **408,** a second amplifier **410,** a first compensating impedance **412,** and a second compensating impedance **414.** In this example, the first amplifier **408** and second amplifier **410** are differential amplifiers such as, for example, op-amps. The first compensating impedance **412** is in signal communication with a non-inverting input **416** of the first amplifier **408** and the second compensating impedance **414** is in signal communication with a non-inverting input **418** of the second amplifier **410.** The first current source **402** is in signal communication with an inverting input **422** of the first amplifier **408** and the second current source **404** is signal communication with both the inverting input **422** of the first amplifier **408** and an inverting input **424** of the second amplifier **410.** The first current source **402** is also in signal communication with a signal ground **423.** In operation, the first and second current sources **402** and **404** inject respective currents $I_{S-offset}$ **426** and $I_{D-offset}$ **428** directly into a first negative input node, which corresponds to the inverting input **422** of the first amplifier **408.**

A sensor such as the TCD in the bridge circuit described above may be connected with one lead from the bridge circuit to be in signal communication with a positive signal input **430** of the amplifier circuit **400** and the other lead connected in signal communication with a negative signal input **432** of the amplifier circuit **400.** In this example, a positive input signal **434** injected into the positive signal input **430** passes through the first compensating impedance **412** to the non-inverting input **416** of the first amplifier **408.** Similarly, a negative input signal **436** injected into the negative signal input **432** passes through the second compensating impedance **414** into the non-inverting input **418** of the second amplifier **410.** The amplifier circuit **400** includes a positive differential output **440** corresponding to the output of the first amplifier **408** and a negative differential output **442** corresponding to the output of the second amplifier **410.** The feedback network **406** is in signal communication with both the outputs **440** and **442** of the first and second amplifiers **408** and **410** and both the inverting inputs **422** and **424** of the first and second amplifiers **408** and **410.** The feedback network **406** may include a first feedback impedance **444,** second feedback impedance **446,** and a gain impedance **448.**

The amplifier circuit **400** may be considered as having "programmable gain" capabilities implemented by selecting a suitable impedance value for a selected gain impedance **448.** In general, the operating characteristics of the first and second amplifiers **408** and **410** may be balanced. Accordingly, the first and second amplifiers **408** and **410** may have substantially the same specifications, the first and second feedback impedances **444** and **446** may be of the same impedance value, and the first and second compensating impedances **412** and **414** may be set to the same compensating impedance value. The gain impedance **448** provides the "programmable gain" capabilities in that the value of the gain impedance **448** may be varied or selected to achieve a desired gain for the amplifier circuit **400.**

In this example, the values of the first feedback impedance **444,** the second feedback impedance **446,** and the gain impedance **448** may depend on achieving a desired range of offset voltages at the negative input nodes that correspond to the inverting inputs **422** and **424** of the first and second amplifiers **406** and **410,** respectively. The desired range of offset voltages may depend on the range of sensor offsets expected from a selected sensor and on the current level of the input offset current. In this example, the impedance values may be selected as follows: the first and second feedback impedances **444** and **446** may be each set to an impedance value of *(g-1)\*R* where "*g*" is the gain of each amplifier **408** and **410,** and the gain impedance **448** may be correspondingly set to 2R, where "*R*" is a resistance value (i.e., a "real" impedance value) that a user may set depending on specific implementations according to a desired total gain. With these values for the first and second feedback impedances **444** and **446,** and for the gain impedance **408,** the offset voltage $V_{offset}$ may be adjusted using the following relationship:

$$V_{offset} = \frac{(g-1)R}{g} I_{S-offset} + \frac{2R(g-1)}{g} I_{D-offset} \, .$$

Once a user has achieved a desired gain from the amplifier circuit **400,** the voltage offset $V_{offset}$ may be adjusted to compensate for sensor offset by adjusting either, or both, of the offset currents, $I_{S-offset}$ **426** and $I_{D-offset}$ **428.**

Accordingly, the amplifier circuit **400** illustrated in Figure 4 provides a user with the ability to control the current sources **402** and/or **404** to inject the offset currents $I_{S-offset}$ **426** and $I_{D-offset}$ **428** at desired current levels to create a voltage offset $V_{offset}$ that offsets the sensor offset contribution to the input signal. The current sources **402** and **404** simplify the process of sensor offset compensation by providing the user with one or two parameters to adjust: $I_{V\text{-}offset}$ **426** and/or $I_{S\text{-}offset}$ **428.** In one example, the user may set up a sensor to generate a 'zero' signal. Thus, in setting the input offset adjustment, the user may configure a sensor to generate a signal that is selected to represent a zero level. In the case of a TCD employed with a GC, the sensor may be configured to provide a balanced signal level at the sensor output leads. That is, the sensor may be subjected to a temperature at which all of the resistor filaments should be of equal value. The user may then adjust the current source(s) **402** and/or **404** to generate an $I_{D\text{-}offset}$ **426** and/or $I_{S\text{-}offset}$ **428** that applies a $V_{offset}$ at the inverting inputs **422** and **424,** which generates an output representative of a zero level of sample gas at the positive and negative outputs **440** and **442.**

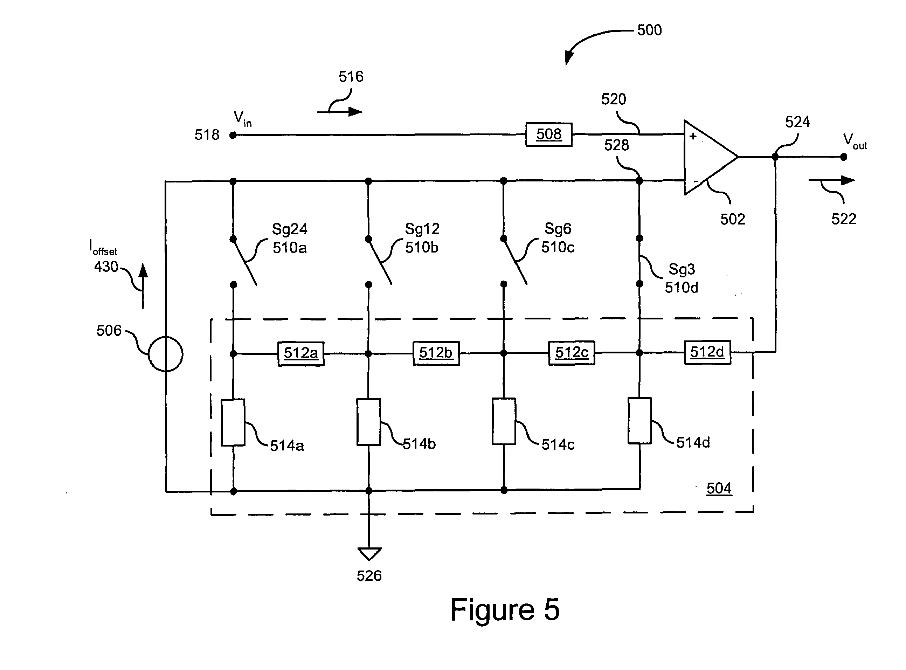

Figure 5 is a schematic diagram of another example of a single-ended, programmable gain amplifier circuit **500** consistent with the present invention. The amplifier circuit **500** may include an amplifier **502,** a feedback network **504,** a current source **506,** a compensating impedance **508,** and a plurality of switches such as four switches **510a, 510b, 510c** and **510d.** The feedback network **504** may include an R2R impedance ladder network formed by series ladder impedances **512a, 512b, 512c** and **512d,** and parallel ladder impedances **514a, 514b, 514c** and **514d,** which are utilized as feedback for the amplifier **502.** It is appreciated by those skilled in the art that while four switches **510a-d,** four series ladder impedances **512a-d,** and four parallel impedances **512a-d** are shown, this number is an example and any number of these components may be utilized without departing from the scope of this invention. An input signal **516** may be received via signal input **518,** which is in signal communication with a non-inverting input **520** of the amplifier **502** via the compensating impedance **508.** The amplifier **502** outputs an amplified signal **522** at a signal output **524** of the amplifier **502** relative to signal ground **526.**

The plurality of switches **510a, 510b, 510c, 510d** may be a switch-bank that allows a user to select from a set of a plurality of gain settings. In this example, the switch Sg3 **510d** may be selected to set the gain of the amplifier circuit **500** to a gain value of 3. Similarly, the switch Sg6 **510c** may be selected to set the gain to a gain value of 6, the switch Sg12 **510b** may be selected to set the gain to a gain value of 12, and the switch Sg24 **510a** may be selected to set the gain to a gain value of 24. The gain settings are dependent on the configuration of the impedance elements in the R2R feedback network **504** for each switch setting. For example, the switch Sg3 **510d** is illustrated in a closed state, leaving the impedance element **512d** as the lone feedback impedance element in signal communication with the negative input (i.e., an inverting input **528** of the amplifier **502)** and the output **524** of the amplifier **502.** By opening the switch Sg3 **510d** and closing the switch Sg6 **510c,** the configuration of the R2R feedback network **504** changes to provide an increased feedback impedance relative to the impedance between the negative input node **528** of the inverting input of the amplifier **502** and signal ground **526.** The values of the impedances may be selected such that the gain is thereby effectively doubled (i.e., to a gain value of 6). Similarly, opening the switch Sg6 **510c** and closing the switch Sg12 **510b** raises the gain to a gain value of 12, and opening the switch Sg12 **510b** and closing the switch Sg24 **510a** raises the gain to a gain value of 24.

The current source **506** may be adjusted to control the input offset at the negative amplifier input (i.e., the inverting input **528)** of the amplifier **502.** In this example, the negative input node impedance of the feedback network **504** as seen at the inverting input **528** does not change when a different gain is selected. In this example, the impedance values may be selected as follows: the series ladder impedances **512a, 512b** and **512c** and the parallel ladder impedance **514a** may each be set of an impedance value of $R$, where $R$ is a resistance value; and the parallel ladder impedances **514b, 514c** and **514d** and the series ladder impedance **512d** may each be set to an impedance value of $2R$. Given the impedance values indicated in this example, the voltage offset $V_{offset}$ at the inverting input **528** of the amplifier **502** may be determined according to:

$$V_{offset} = \frac{2R}{3} I_{offset} \ .$$

The user may set the voltage offset $V_{offset}$ to compensate for a determined sensor offset by adjusting the offset current $I_{offset}$ generated by the current source **506.**

The amplifier circuit **500** illustrated in Figure 5 provides a user with the ability to control the current source **506** to inject the offset current $I_{offset}$ to create a voltage offset $V_{offset}$ that offsets the sensor offset contribution to the input signal **516.** The gain may also be programmed using the switches **510a, 510b, 510c, 510d** in a manner that does not change the negative input node impedance of the feedback network **504** as seen at the inverting input **528** of the amplifier circuit **500,** thereby eliminating the effect that changing the gain would otherwise have on the input offset adjustment.

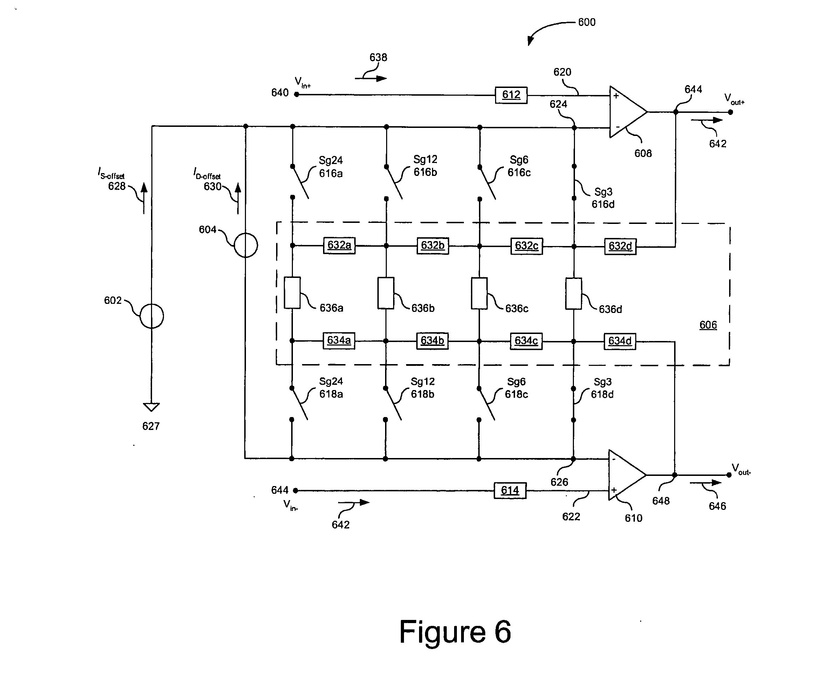

Figure 6 is a schematic diagram of another example of a differential instrumentation, programmable gain amplifier circuit **600** consistent with the present invention. The amplifier circuit **600** may include first and second current sources **602** and **604,** a feedback network **606,** a first amplifier **608,** a second amplifier **610,** a first compensating impedance **612,** a second compensating impedance **614,** a first plurality of switches such as four switches **616a, 616b, 616c, 616d** and a second plurality of switches such as four switches **618a, 618b, 618c, 618d.** In this example, the first amplifier **608** and second amplifier **610** are differential amplifiers such as, for example, op-amps. The first compensating impedance **614** is in signal communication with a non-inverting input **620** of the first amplifier **608** and the second compensating impedance **614** is in signal communication with a non-inverting input **622** of the second amplifier **610.** The first current source **602** is in signal communication with an inverting input **624** of the first amplifier **608.** The second current source **604** is signal communication with both the inverting input **624** of the first amplifier **608** and an inverting input **626** of the second amplifier **610.** The first current source **602** is also in signal communication with a signal ground **627.** In operation, the first and second current sources **602** and **604** inject respective currents $I_{S\text{-}offset}$ **628** and $I_{V\text{-}offset}$ **630** directly into a first negative input node, which corresponds to the inverting input **624** of the first amplifier **608.**

The feedback network **606** may include an R2R impedance ladder network formed by first (i.e., "upper") series ladder impedances **632a, 632b, 632c** and **632d;** second (i.e. "lower") series ladder impedances **634a, 634b, 634c** and **634d;** and parallel ladder impedances **636a, 636b, 636c** and **636d,** which are utilized as feedback for both amplifiers **608** and **610.** It is appreciated by those skilled in the art that while four first switches **616a-d,** four second switches **618a-d,** four first series ladder impedances **632a-d,** four second series ladder impedances **634a-d** and four parallel impedances **636a-d** are shown, this number is an example and any number of these components may be utilized without departing from the scope of this invention.

A first input signal **638** may be received via a signal input **640** (e.g., the positive signal input), which is in signal communication with the non-inverting input **620** of the first amplifier **608** via the first compensating impedance **612.** The first amplifier **608** outputs a first amplified signal **642** at a signal output **644** of the first amplifier **608** relative to signal ground **627.** Similarly, a second input signal **642** may be received via a signal input **644** (e.g., the negative signal input), which is in signal communication with the non-inverting input **622** of the second amplifier **610** via the second compensating impedance **614.** The second amplifier **610** outputs a second amplified signal **646** at a signal output **648** of the second amplifier **610** relative to signal ground **627.** As an example, a sensor may be put in signal communication with the differential positive and negative signal inputs **640** and **644.**

The inverting amplifier input **624** of the first amplifier **608** is in signal communication with the feedback network **606** via the first switch-bank **616a-d** at a first node that corresponds to the inverting input **624** to the first amplifier **608.** The inverting amplifier input **626** of the second amplifier **610** is in signal communication with the feedback network **606** via the second switch-bank **618a-d** at a second node that corresponds to the inverting input **626** to the second amplifier **610.** The R2R impedance ladder network within the feedback network **606** is formed by the parallel ladder impedances **636a-d,** upper series ladder impedances **632a-d,** and lower series ladder impedances **634a-d.**

The settings of the first and second switch-banks **616a-d** and **618a-d** switch the configuration of the impedances in the feedback network **606** to adjust the impedance values to obtain a desired gain. For example, the switch Sg3 **616d** in the first switch-bank **616a-d** and the switch Sg3 **618d** in the second switch-bank **618a-d** may be selected to set the gain of the amplifier circuit **600** to a gain value of 3. Similarly, the switches Sg6 **616c** and **618c** in each switch-bank **616a-d** and **618a-d** may be selected to set the gain to gain value of 6, the switches Sg12 **616b** and **618b** in each switch-bank **616a-d** and **618a-d** may be selected to set the gain to gain value of 12, and the switches Sg24 **616a** and **618a** in each switch-bank **616a-d** and **618a-d** may be selected to set the gain to a gain value of 24. In these examples, the gains are dependent on the impedance of the R2R impedance ladder network, within the feedback network **606,** corresponding to the switch or switches that are closed.

As an example of operation, the first current source **602** injects a current, $I_{S\text{-}offset}$ **628,** at the first node corresponding to the inverting input **624** of the first amplifier **608.** The current, $I_{S\text{-}offset}$ **628,** generates a voltage offset at the inverting input **624** relative to signal ground **627.** The second current source **604** injects a current, $I_{D\text{-}offset}$ **630** into the R2R impedance ladder network to create a constant voltage drop across the R2R impedance ladder network between nodes corresponding to the inverting input **624** of first amplifier **608** and the inverting input **626** of the second amplifier **610.** The first and second current sources **602** and **604** may be adjusted to generate a voltage offset, $V_{offset},$ to compensate for a sensor offset at the signal inputs **640** and **644.** In this example, the impedance values may be selected as follows: upper series impedances **632a, 632b,** and **632c** and lower impedances **634a, 634b,** and **634c** have individual impedance values set to a resistance value of $R$; upper series impedance **632d** and lower series impedance **634d** have individual impedance values set to a resistance value of $2R$; parallel impedances **636b, 636c,** and **636d** have individual impedance values set to a resistance value of $4R$; and parallel impedance **636a** has an impedance value set to a resistance value of $2R$. Given the impedance values indicated in this example, the voltage offset $V_{offset}$ may be determined by:

$$V_{offset} = \frac{2R}{3} I_{S\text{-}offset} + \frac{4R}{3} I_{D\text{-}offset} \ .$$

The amplifier circuit **600** illustrated in Figure 6 provides a user with the ability to control the current sources **602** and/or **604** to inject the offset current to create a voltage offset $V_{offset}$ that offsets the sensor offset contribution to the input signal. The gain may also be programmed using the switches **616a, 616b, 616c, 616d** and **618a, 618b, 618c, 618d** in a manner that does not change the impedance at the differential input (i.e., the input impedances of the feedback network **606** at the inverting inputs **624** and **626** of first and second amplifiers **608** and **610,** respectively) of the amplifier circuit **600,** thereby eliminating the effect that changing the gain would otherwise have on the input offset adjustment.

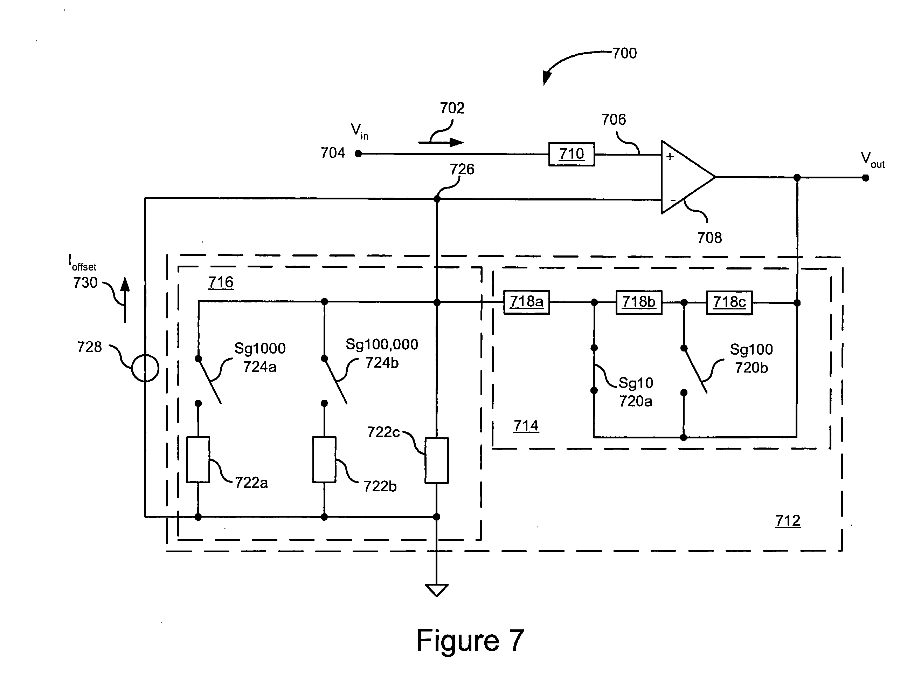

Figure 7 is a schematic diagram of another example of a single-ended, programmable gain amplifier circuit **700** consistent with the present invention. The amplifier circuit **700** receives an input signal **702** at a signal input **704,** which is in signal communication with a non-inverting input **706** of an amplifier **708** via a compensating impedance **710.** The amplifier circuit **700** may include a feedback network **712** that has an R2R feedback network forming a voltage divider. The feedback network **712** may include a first feedback impedance network **714** and a second feedback impedance network **716.** The first feedback impedance network **714** may include series-connected impedances **718a, 718b,** and **718c.** A first gain switch-bank that includes switches Sg10 **720a** and Sg100 **720b** is capable of adjusting the impedance of the first feedback impedance network **714** by switching in/out the series-connected impedances **718a, 718b,** and **718c** corresponding to the switch settings. The second feedback impedance network **716** includes parallel-connected impedances **722a, 722b,** and **722c.** A second gain switch-bank that includes switches Sg1000 **724a** and Sg100,000 **724b** is capable of adjusting the impedance of the second feedback impedance network **716** by switching in/out the parallel-connected impedances **722a, 722b,** and **722c** corresponding to the switch settings. In this example, switch Sg10 **720a** sets the gain of the single-ended programmable gain amplifier circuit **700** to a gain value of 10 when it is closed. Likewise, switch Sg100 **720b** sets the gain to a gain value of 100, switch Sg1000 **724a** sets the gain to a gain value of 1000, and switch Sg100,000 **724b** sets the gain to a gain value of 100,000. The gain at each switch setting is determined by the impedance at each branch (i.e., the first feedback impedance network **714** and the second feedback impedance network **716)** of the voltage divider formed by the R2R feedback network of the feedback network **712.**

In this example, the amplifier circuit **700** has the property that the impedance of the negative input node corresponding to an inverting input **726** of the amplifier element **708** is constant regardless of the gain selected. As an example, the impedance values of the impedances may be selected as follows: the impedance **718a** has a resistance value of $9R$, the impedance **718b** has a resistance value of $81R$, the impedance **718c** has a resistance value of $810R$, the impedance **722a** has a resistance value of $100R$, the impedance **722b** has a resistance value of $10R$, the impedance **722c** has a resistance value of R, and the compensating impedance **710** has a resistance value of $\dfrac{9}{10}R$. Given these impedance values, the impedance at a node corresponding to the inverting input **726,** of the amplifier **708,** is $\dfrac{9}{10}R$. A current source **728** injects a constant offset current, $I_{offset}$ **730** into node **726** to generate a constant offset voltage $V_{offset}$. Based on the impedance values of this example, the voltage offset $V_{offset}$ may be obtained utilizing the following relationship:

$$V_{offset} \frac{9}{10} R I_{offset} \ .$$

The amplifier circuit **700** illustrated in Figure 7 provides a user with the ability to control the current source **728** to inject the offset current $I_{offset}$ to create a voltage offset $V_{offset}$ that offsets the sensor offset contribution to the input signal **702.** The gain may also be programmed using the switches **720a, 720b** and **724a, 724b** in a manner that does not change the impedance at the input of the amplifier circuit **700,** thereby eliminating the effect that changing the gain would otherwise have on the input offset adjustment.

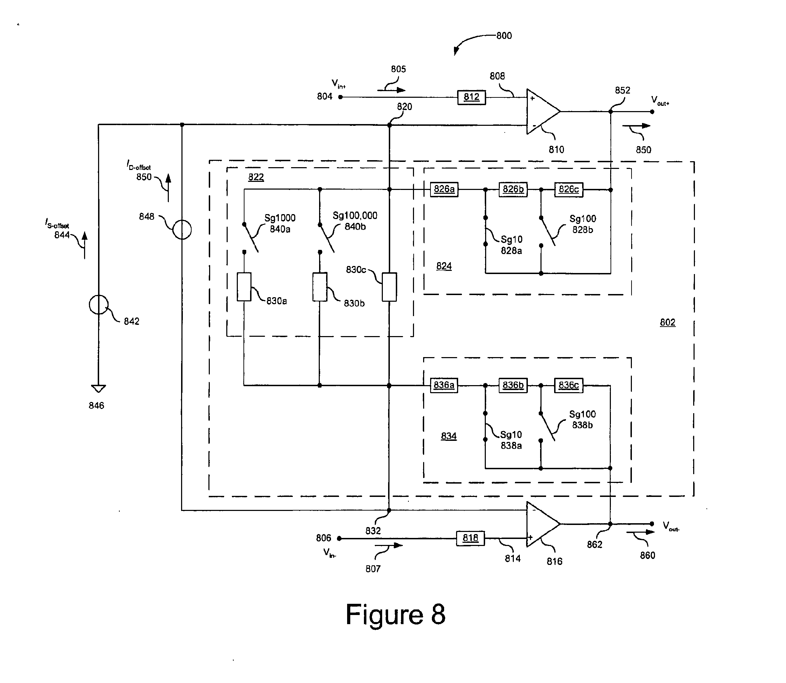

Figure 8 is a schematic diagram of another example of a differential instrumentation programmable gain amplifier circuit **800** consistent with the present invention. The amplifier circuit **800** may include a feedback network **802** with switch-selectable impedance levels for both the gain impedance and the feedback impedance. A sensor may be in signal communication with the differential positive and negative inputs **804** and **806,** at which first and second input signals **805** and **807** may be respectively received from the sensor. The positive signal input **804** is in signal communication with the non-inverting amplifier input **808** of a first amplifier **810** via a first compensating impedance **812.** The negative signal input **806** is in signal communication with the non-inverting amplifier input **814** of a second amplifier **816** via a second compensating impedance **818.** The first amplifier **810** outputs a first amplified signal **850** at a signal output **852** of the first amplifier **810.** The second amplifier **816** outputs a second amplified signal **860** at a signal output **862** of the second amplifier **816.**

An inverting amplifier input **820** of the first amplifier **810** is in signal communication with a gain impedance network **822** and to a first feedback impedance network **824**. The first feedback impedance network **824** forms a branch of series-connected feedback impedances **826a, 826b** and **826c** communicating with a first switch-bank of switches **828a** and **828b**. The gain impedance network **822** forms a branch of parallel-connected gain impedances **830a, 830b** and **830c** between nodes **820** and **832** corresponding to the inverting inputs of the first and second amplifiers **810** and **816,** respectively. Node **820** is in signal communication with the first feedback impedance network **824** and node **832** is in signal communication with a second feedback impedance network **834**. The second feedback impedance network **834** may form a branch of series-connected feedback impedances **836a, 836b** and **836c** communicating with a second switch-bank of switches **838a** and **838b**. The impedances **830a-c** of the gain impedance network **822** are in signal communication with a third switch bank of switches **840a** and **840b**. The gain may be set by selecting one of switches Sg10 **828a** and **838a,** Sg100 **828b** and **838b,** Sg1000 **840a,** or Sg100,000 **840b**. Switches Sg10 **828a** and **838a,** and Sg100 **828b** and **838b,** in the respective first and second switch-banks adjust the impedance of first and second feedback impedance networks **824** and **834** by switching in/out the series-connected impedances **826a-c** and **836a-c** in each branch to connect with the impedance **830c** in the gain impedance network **822**. Switches Sg1000 **840a** and Sg100,000 **840b** of the third switch-bank adjust the impedance of the gain impedance network **822** by switching in/out the parallel-connected impedances **830a-c** to connect with the impedances of the first and second feedback impedance networks **824** and **834.**

A first current source **842** injects a current $I_{S\text{-}offset}$ **844** at node **820** at the inverting input of the first amplifier **810**. The current $I_{S\text{-}offset}$ **844** generates a voltage offset relative to signal ground **846** at the node **820**. A second current source **848** injects a current $I_{D\text{-}offset}$ **850** into the gain impedance network **822** to create a constant voltage drop across the gain impedance network **822** between nodes **820** and **832**. The first and/or second current sources **842** and **848** may be adjusted to generate a total voltage offset, $V_{offset}$, to compensate for a sensor offset at the signal inputs **804** and **806**. As an example, the impedance values may be selected as follows: the impedances **826a** and **836a** are set to a resistance value of $9R$, the impedances **826b** and **836b** are set to a resistance value of $81R$, the impedances **826c** and **836c** are set to a resistance value of $810R$, the impedance **830a** is set to a resistance value of $200R$, the impedance **830b** is set to a resistance value of $20R$, and the impedance **830c** is set to a resistance value of $2R$. Given these values, the voltage offset, $V_{offset}$, may be determined by:

$$V_{offset} = \frac{9}{10} R I_{S-offset} + \frac{18}{10} R I_{D-offset} \; .$$

The amplifier circuit **800** illustrated in Figure 8 provides a user with the ability to control the current sources **842** and/or **848** to inject the offset current to create a voltage offset $V_{offset}$ that offsets the sensor offset contribution to the input signal. The gain may also be programmed using the switches **828a-b, 838a-b** and **840a-b** in a manner that does not change the impedance at the differential input (i.e., the input impedances of the feedback network **802** at the inverting inputs **820** and **832** of first and second amplifiers **810** and **816,** respectively) of the amplifier circuit **800,** thereby eliminating the effect that changing the gain would otherwise have on the input offset adjustment.

The examples of amplifier circuits described with reference to Figures 3-8 allow a user to set an input offset to compensate for a sensor offset. For the single-ended amplifier circuits such as the amplifier circuits **300, 500** and **700** shown in Figures 3, 5, and 7, a TCD in a bridge circuit may have one lead from the bridge circuit in signal communication with the single-ended input and the other lead grounded. In a GC application, the single-ended amplifier circuit may be configured and set to operate in the presence of the reference gas only. The input offset may be adjusted by adjusting the current source in the single-ended amplifier circuit until the output of the single-ended amplifier circuit is zero. Consequently, in the presence of a sample gas, the entire output gain range is available during operation.

Similarly, for the differential instrumentation amplifier circuits such as the amplifier circuits **400, 600** and **800** in Figures 4, 6 and 8, the leads of the bridge circuit of the TCD may be in signal communication with the differential inputs of the differential instrumentation amplifier circuits. The input offset may then be adjusted by adjusting the current (s) generated by the current source(s) in the differential instrumentation amplifier circuits with the TCD in the presence of a reference gas.

The programmable gain amplifier circuits such as the amplifier circuits **500, 600, 700** and **800** in Figures 5, 6, 7 and 8 enable the user to easily program the gain. The gain may be programmed by setting switches as described above or other suitable gain-adjusting devices or means. The switches may be implemented using any type of switch (*e.g.* a set of dipswitches, or electronic switches that may be controlled by software). Equal node impedances are provided for all gains, such that the required input offset adjustment is equal for all gains of the amplifier circuit.

One or more implementations may be configured such that the input offset adjustment is proportional to the bi-directional (positive or negative) offset input current. For a bridge circuit, a ratio-metric input offset adjustment can be realized by driving the offset adjustment current from a digital to analog converter with the bridge excitation as a reference.

It will be understood that various aspects or details of the invention may be changed without departing from the scope of the invention. For example, the impedance networks described by example above may be implemented using a variety of topographies that provide a constant impedance at the negative input of the amplifier elements regardless of the overall gain selected for the circuit. Moreover, specific impedances, gain settings, resistances, current and voltage offsets, and other values have been provided for purposes of illustration and example and thus are not limiting. Furthermore, the foregoing description is for the purpose of illustration only, and not for the purpose of limitation- the invention being defined by the claims.

**Claims**

1. An amplifier circuit (300, 400, 500, 600, 700, 800), comprising:

   an amplifier (306; 408, 410; 502; 608, 610; 708; 810, 816), having a non-inverting input (320; 416, 418; 520; 620, 622; 706; 808, 814), an inverting input (318; 422, 424; 528; 624, 626; 726; 820, 832), and an amplifier output (322; 440, 442; 524; 644, 646; 852, 862);
   a feedback network (308, 406, 504, 606, 712, 802) in signal communication with the amplifier output (322; 440, 442; 524; 644, 646; 852, 862) and the inverting input (318; 422, 424; 528; 624, 626; 726; 820, 832); and
   at least one current source (310; 402, 404; 506; 602, 604; 728; 842, 848) in signal communication with the inverting input (318; 422, 424; 528; 624, 626; 726; 820, 832), the one or at least one of the current sources being adjustable to a plurality of selectable input offsets to generate a plurality of corresponding voltage offsets at the inverting input.

2. The amplifier circuit of claim 1, wherein the feedback network (308, 406, 504, 606, 712, 802) includes a first feedback impedance element (314; 444, 446; 512a-d; 632a-d, 634a-d; 718a-c; 826a-c, 836a-c) in signal communication with the amplifier output and the inverting input, and a second feedback impedance element (316; 448; 514a-d; 636a-d; 722a-b; 830a-c) in signal communication with the inverting input.

3. The amplifier circuit of claim 2, wherein the first feedback impedance element (314; 444, 446; 512a-d; 632a-d, 634a-d; 718a-c; 826a-c, 836a-c) has an impedance value dependent on the gain of the amplifier.

4. The amplifier circuit of claim 1, 2 or 3, wherein the feedback network (504, 606, 712, 802) is adjustable to a plurality of gain settings of the amplifier circuit, and the feedback network is configured such that an impedance of the feedback network at the inverting input (528; 624, 626; 726; 820, 832) is equal for all gain settings, whereby in particular the plurality of selectable input offsets and the plurality of corresponding voltage offsets are independent of the plurality of gain settings.

5. The amplifier circuit of claim 1, 2 or 3, wherein:

   the feedback network (504, 606, 712, 802) includes a plurality of impedance elements in signal communication with the inverting input (528; 624, 626; 726; 820, 832), and a plurality of switches (510a-d; 616a-d, 618a-d; 720a-b, 722a-b; 828a-b, 838a-b, 840a-b) adjustable to a plurality of gain settings of the amplifier circuit; and
   the feedback network is configured such that the impedance of the feedback network at the inverting input (528; 624, 626; 726; 820, 832) is equal for all gain settings, whereby in particular the plurality of selectable input offsets and the plurality of corresponding voltage offsets are independent of the plurality of gain settings.

6. The amplifier circuit of claim 5, wherein the plurality of impedance elements includes a plurality of series-connected impedance elements (512a-d; 632a-d, 634a-d; 718a-c; 826a-c, 836a-c) in signal communication with the inverting input (528; 624, 626; 726; 820, 832) and the amplifier output (528; 624, 626; 726; 820, 832), and a plurality of parallel-connected impedance elements (514a-d; 636a-d; 722a-b; 830a-c) in signal communication with the inverting input.

7. The amplifier circuit of claim 1, wherein:

   the amplifier is a first amplifier (408; 608; 810), the non-inverting input is a first non-inverting input, the inverting input is a first inverting input, and the amplifier output is a first amplifier output;

the amplifier circuit further includes a second amplifier (410; 610; 816) having a second non-inverting input, a second inverting input, and a second amplifier output; and
the feedback network (406, 606, 802) is in signal communication with the second amplifier output and the second inverting input, in addition to the first amplifier output and the first inverting input.

8. The amplifier circuit of claim 7, wherein:

the current source includes a first current source (402; 602; 842) in signal communication with the first inverting input (422; 624; 820), and a second current source (404; 604; 848) in signal communication with the first inverting input (408; 608; 810) and with the second inverting input (424; 626; 832); and
at least one of the first and second current sources (402, 404; 602, 604; 842, 848) is adjustable to the plurality of selectable input offsets to generate a plurality of corresponding voltage offsets at the first and second inverting inputs.

9. The amplifier circuit of claim 7 or 8, wherein the feedback network (406, 606, 802) includes a first feedback impedance element (444; 632a-d; 826a-c) in signal communication with the first amplifier output (440; 644; 852) and the first inverting input (408; 608; 810), a second feedback impedance element (446; 634a-d; 836a-c) in signal communication with the second amplifier output (442; 646; 862) and the second inverting input (424; 626; 832), and a gain impedance element (448; 636a-d; 830a-c) in signal communication with the first inverting input and the second inverting input.

10. The amplifier circuit of claim 9, wherein the first feedback impedance element (444; 632a-d; 826a-c) and the second feedback impedance element (446; 634a-d; 836a-c) each have an impedance value dependent on the gain of each of the first and second amplifiers.

11. The amplifier circuit according to any of claims 7 to 10, wherein the feedback network (406, 606, 802) is adjustable to a plurality of gain settings of the amplifier circuit, and the feedback network is configured such that the impedance between the first and second inverting inputs is equal for all gain settings, whereby in particular the plurality of selectable input offsets and the plurality of corresponding voltage offsets are independent of the plurality of gain settings.

12. The amplifier circuit according to any of claims 7 to 11, wherein:

the feedback network (606, 802) includes a plurality of impedance elements (632a-b, 634a-b, 636a-d; 826a-b, 836a-b, 830a-c) in signal communication with the first and/or second inverting inputs (624, 626; 820, 832), and a plurality of switches (616a-d, 618a-d; 828a-b, 838a-b, 840a-b) adjustable to a plurality of gain settings of the amplifier circuit; and
the feedback network is configured such that the impedance between the first and second inverting inputs is equal for all gain settings, whereby in particular the plurality of selectable input offsets and the plurality of corresponding voltage offsets are independent of the plurality of gain settings.

13. The amplifier circuit of claim 12, wherein the plurality of impedance elements includes:

a plurality of first series-connected impedance elements (632a-d; 826a-c) in signal communication with the first inverting input and the first amplifier output;
a plurality of second series-connected impedance elements (634a-d; 836a-c) in signal communication with the second inverting input and the second amplifier output; and
a plurality of parallel-connected impedance elements (636a-d; 830a-c) in signal communication with the first and second inverting inputs.

14. The amplifier circuit of any of claims 1-13, wherein at least one amplifier (306; 408, 410; 502; 608, 610; 708; 810, 816) is in signal communication with a gas detector (108).

15. The amplifier circuit of any of claims 1-14, wherein at least one amplifier (306; 408, 410; 502; 608, 610; 708; 810, 816) is in signal communication with a bridge output of a bridge circuit (200), and the bridge circuit includes at least two temperature-sensitive resistive elements (208-220), one of the resistive elements communicating with a first gas source (120) and the other resistive element communicating with a second gas source (124).

16. The amplifier circuit of any of claims 1-15, wherein at least one amplifier (306; 408, 410; 502; 608, 610; 708; 810, 816) is in signal communication with a gas detector (108), and the gas detector is in flow communication with a chromatographic column (104).

17. A method for adjusting an input offset at an input of an amplifier circuit (300, 400, 500, 600, 700, 800), comprising:

amplifying an input signal in a differential amplifier (306; 408, 410; 502; 608, 610; 708; 810, 816) to generate an output signal;
feeding back the output signal through a feedback network (308, 406, 504, 606, 712, 802) to an inverting input of the differential amplifier; and
driving an adjustable current into the inverting input, the adjustable current being adjustable to a plurality of selectable input offsets to generate a plurality of corresponding voltage offsets at the inverting input.

18. The method of claim 17, further including adjusting the feedback network (504, 606, 712, 802) to a selected one of a plurality of selectable gain settings of the amplifier circuit, wherein the impedance at the inverting input is equal for any gain setting selected and adjustment of the current is independent of the selected gain setting.

19. The method of claim 17 or 18, further including receiving an input signal at a non-inverting input of the differential amplifier from a gas detector (108).

20. The method of any of claims 17-19, wherein the input signal is indicative of a concentration of a gas flowed from a chromatographic column (104).

**Amended claims in accordance with Rule 137(2) EPC.**

**1.** An amplifier circuit (300, 400, 500, 600, 700, 800), comprising:

an amplifier (306; 408, 410; 502; 608, 610; 708; 810, 816), having a non-inverting input (320; 416, 418; 520; 620, 622; 706; 808, 814), an inverting input (318; 422, 424; 528; 624, 626; 726; 820, 832), and an amplifier output (322; 440, 442; 524; 644, 646; 852, 862);
a feedback network (308, 406, 504, 606, 712, 802) in signal communication with the amplifier output (322; 440, 442; 524; 644, 646; 852, 862) and the inverting input (318; 422, 424; 528; 624, 626; 726; 820, 832); and
at least one current source (310; 402, 404; 506; 602, 604; 728; 842, 848) in signal communication with the inverting input (318; 422, 424; 528; 624, 626; 726; 820, 832), the one or at least one of the current sources being adjustable to a plurality of selectable input offsets to generate a plurality of corresponding voltage offsets at the inverting input;
wherein the feedback network (504, 606, 712, 802) is adjustable to a plurality of gain settings of the amplifier circuit, and the feedback network is configured such that an impedance of the feedback network at the inverting input (528; 624, 626; 726; 820, 832) is equal for all gain settings, whereby in particular the plurality of selectable input offsets and the plurality of corresponding voltage offsets are independent of the plurality of gain settings.

**2.** The amplifier circuit of claim 1, wherein the feedback network (308, 406, 504, 606, 712, 802) includes a first feedback impedance element (314; 444, 446; 512a-d; 632a-d, 634a-d; 718a-c; 826a-c, 836a-c) in signal communication with the amplifier output and the inverting input, and a second feedback impedance element (316; 448; 514a-d; 636a-d; 722a-b; 830a-c) in signal communication with the inverting input.

**3.** The amplifier circuit of claim 2, wherein the first feedback impedance element (314; 444, 446; 512a-d; 632a-d, 634a-d; 718a-c; 826a-c, 836a-c) has an impedance value dependent on the gain of the amplifier.

**4.** The amplifier circuit of claim 1, 2 or 3, wherein:

the feedback network (504, 606, 712, 802) includes a plurality of impedance elements in signal communication with the inverting input (528; 624, 626; 726; 820, 832), and a plurality of switches (510a-d; 616a-d, 618a-d; 720a-b, 722a-b; 828a-b, 838a-b, 840a-b) adjustable to a plurality of gain settings of the amplifier circuit; and
the feedback network is configured such that the impedance of the feedback network at the inverting input (528; 624, 626; 726; 820, 832) is equal for all gain settings, whereby in particular the plurality of selectable input offsets and the plurality of corresponding voltage offsets are independent of the plurality of gain settings.

**5.** The amplifier circuit of claim 4, wherein the plurality of impedance elements includes a plurality of series-connected impedance elements (512a-d; 632a-d, 634a-d; 718a-c; 826a-c, 836a-c) in signal communication with the inverting input (528; 624, 626; 726; 820, 832) and the amplifier output (528; 624, 626; 726; 820, 832), and a plurality of parallel-connected impedance elements (514a-d; 636a-d; 722a-b; 830a-c) in signal communication with the inverting input.

**6.** An amplifier circuit (300, 400, 500, 600, 700, 800), comprising:

an amplifier (306; 408, 410; 502; 608, 610; 708; 810, 816), having a non-inverting input (320; 416, 418; 520; 620, 622; 706; 808, 814), an inverting input (318; 422, 424; 528; 624, 626; 726; 820, 832), and an amplifier output (322; 440, 442; 524; 644, 646; 852, 862); a feedback network (308, 406, 504, 606, 712, 802) in signal communication with the amplifier output (322; 440, 442; 524; 644, 646; 852, 862) and the inverting input (318; 422, 424; 528; 624, 626; 726; 820, 832); and

at least one current source (310; 402, 404; 506; 602, 604; 728; 842, 848) in signal communication with the inverting input (318; 422, 424; 528; 624, 626; 726; 820, 832), the one or at least one of the current sources being adjustable to a plurality of selectable input offsets to generate a plurality of corresponding voltage offsets at the inverting input;

wherein:

the amplifier is a first amplifier (408; 608; 810), the non-inverting input is a first non-inverting input, the inverting input is a first inverting input, and the amplifier output is a first amplifier output;

the amplifier circuit further includes a second amplifier (410; 610; 816) having a second non-inverting input, a second inverting input, and a second amplifier output;

the feedback network (406, 606, 802) is in signal communication with the second amplifier output and the second inverting input, in addition to the first amplifier output and the first inverting input; and

the feedback network (406, 606, 802) is adjustable to a plurality of gain settings of the amplifier circuit, and the feedback network is configured such that the impedance between the first and second inverting inputs is equal for all gain settings, whereby in particular the plurality of selectable input offsets and the plurality of corresponding voltage offsets are independent of the plurality of gain settings.

**7.** The amplifier circuit of claim 6, wherein:

the current source includes a first current source (402; 602; 842) in signal communication with the first inverting input (422; 624; 820), and a second current source (404; 604; 848) in signal communication with the first inverting input (408; 608; 810) and with the second inverting input (424; 626; 832); and

at least one of the first and second current sources (402, 404; 602, 604; 842, 848) is adjustable to the plurality of selectable input offsets to generate a plurality of corresponding voltage offsets at the first and second inverting inputs.

**8.** The amplifier circuit of claim 6 or 7, wherein the feedback network (406, 606, 802) includes a first feedback impedance element (444; 632a-d; 826a-c) in signal communication with the first amplifier output (440; 644; 852) and the first inverting input (408; 608; 810), a second feedback impedance element (446; 634a-d; 836a-c) in signal communication with the second amplifier output (442; 646; 862) and the second inverting input (424; 626; 832), and a gain impedance element (448; 636a-d; 830a-c) in signal communication with the first inverting input and the second inverting input.

**9.** The amplifier circuit of claim 8, wherein the first feedback impedance element (444; 632a-d; 826a-c) and the second feedback impedance element (446; 634a-d; 836a-c) each have an impedance value dependent on the gain of each of the first and second amplifiers.

**10.** The amplifier circuit according to any of claims 6 to 9, wherein:

the feedback network (606, 802) includes a plurality of impedance elements (632a-b, 634a-b, 636a-d; 826a-b, 836a-b, 830a-c) in signal communication with the first and/or second inverting inputs (624, 626; 820, 832), and a plurality of switches (616a-d, 618a-d; 828a-b, 838a-b, 840a-b) adjustable to a plurality of gain settings of the amplifier circuit; and

the feedback network is configured such that the impedance between the first and second inverting inputs is equal for all gain settings, whereby in particular the plurality of selectable input offsets and the plurality of corresponding voltage offsets are independent of the plurality of gain settings.

**11.** The amplifier circuit of claim 10, wherein the plurality of impedance elements includes:

a plurality of first series-connected impedance elements (632a-d; 826a-c) in signal communication with the first inverting input and the first amplifier output;
a plurality of second series-connected impedance elements (634a-d; 836a-c) in signal communication with the second inverting input and the second amplifier output; and
a plurality of parallel-connected impedance elements (636a-d; 830a-c) in signal communication with the first and second inverting inputs.

**12.** The amplifier circuit of any of claims 1 to 11, wherein at least one amplifier (306; 408, 410; 502; 608, 610; 708; 810, 816) is in signal communication with a gas detector (108).

**13.** The amplifier circuit of any of claims 1 to 12, wherein at least one amplifier (306; 408, 410; 502; 608, 610; 708; 810, 816) is in signal communication with a bridge output of a bridge circuit (200), and the bridge circuit includes at least two temperature-sensitive resistive elements (208-220), one of the resistive elements communicating with a first gas source (120) and the other resistive element communicating with a second gas source (124).

**14.** The amplifier circuit of any of claims 1 to 13, wherein at least one amplifier (306; 408, 410; 502; 608, 610; 708; 810, 816) is in signal communication with a gas detector (108), and the gas detector is in flow communication with a chromatographic column (104).

**15.** A method for adjusting an input offset at an input of an amplifier circuit (300, 400, 500, 600, 700, 800), comprising:

amplifying an input signal in a differential amplifier (306; 408, 410; 502; 608, 610; 708; 810, 816) to generate an output signal;
feeding back the output signal through a feedback network (308, 406, 504, 606, 712, 802) to an inverting input of the differential amplifier;
driving an adjustable current into the inverting input, the adjustable current being adjustable to a plurality of selectable input offsets to generate a plurality of corresponding voltage offsets at the inverting input; and
adjusting the feedback network (504, 606, 712, 802) to a selected one of a plurality of selectable gain settings of the amplifier circuit, wherein the impedance at the inverting input is equal for any gain setting selected and adjustment of the current is independent of the selected gain setting.

**16.** The method of claim 15, further including receiving an input signal at a non-inverting input of the differential amplifier from a gas detector (108).

**17.** The method of any of claims 15 or 16, wherein the input signal is indicative of a concentration of a gas flowed from a chromatographic column (104).

GC 104 — Detector 108 — 112 — 116

Sample Gas ("SAMPLE") 120

Reference Gas ("REF") 124

100

128

132

136

140

Figure 1

Figure 2

Figure 3

EP 2 075 910 A1

Figure 4

Figure 5

Figure 6

Figure 7

Figure 8

**European Patent Office**

**EUROPEAN SEARCH REPORT**

Application Number

EP 07 02 5219

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/115047 A1 (D ABRAMO PAOLO [IT] ET AL) 24 May 2007 (2007-05-24)<br><br>* figure 1 *<br>----- | 1-3, 7-10, 14-17, 19,20 | INV.<br>H03F3/45<br>H03F1/30 |
| X | US 2007/241813 A1 (FREEKE ARNOLD J [NL]) 18 October 2007 (2007-10-18)<br><br>* figures 2,3 *<br>----- | 1-3, 7-10, 14-17, 19,20 | |
| X | US 7 304 534 B2 (KOLLER RAINER [AT] ET AL) 4 December 2007 (2007-12-04)<br>* figures 1,2 *<br>----- | 1-3,17, 19,20 | |
| X | US 7 095 275 B2 (MIYAZAKI KATSUMI [JP]) 22 August 2006 (2006-08-22)<br>* figure 1 *<br>----- | 1,7,10, 14-16 | |
| A | US 7 117 714 B2 (NAKAYAMA AKIRA [JP]) 10 October 2006 (2006-10-10)<br>* abstract *<br>----- | 1 | TECHNICAL FIELDS SEARCHED (IPC)<br><br>H03F<br>G01N |
| A | US 5 146 788 A (RAYNES JOHN W [US]) 15 September 1992 (1992-09-15)<br>* abstract *<br>----- | 1 | |
| A | US 5 379 630 A (LACEY RICHARD F [US]) 10 January 1995 (1995-01-10)<br>* figure 1 *<br>----- | 14-16, 19,20 | |
| A | US 2005/265422 A1 (BONNE ULRICH [US]) 1 December 2005 (2005-12-01)<br>* figures 1,2 *<br>----- | 14-16, 19,20 | |

The present search report has been drawn up for all claims

| Place of search | Date of completion of the search | Examiner |
|---|---|---|
| Munich | 3 June 2008 | Agerbaek, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 02 5219

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2008

| Patent document cited in search report | | Publication date | Patent family member(s) | | Publication date |
|---|---|---|---|---|---|
| US 2007115047 | A1 | 24-05-2007 | DE | 10345100 A1 | 28-04-2005 |
| | | | EP | 1665521 A2 | 07-06-2006 |
| | | | WO | 2005036733 A2 | 21-04-2005 |
| | | | JP | 2007534205 T | 22-11-2007 |
| US 2007241813 | A1 | 18-10-2007 | CN | 1993883 A | 04-07-2007 |
| | | | WO | 2005114834 A1 | 01-12-2005 |
| | | | JP | 2007538449 T | 27-12-2007 |
| US 7304534 | B2 | 04-12-2007 | DE | 102005007632 A1 | 24-08-2006 |
| | | | US | 2006186954 A1 | 24-08-2006 |
| US 7095275 | B2 | 22-08-2006 | CN | 1578126 A | 09-02-2005 |
| | | | JP | 2005020232 A | 20-01-2005 |
| | | | KR | 20050001317 A | 06-01-2005 |
| | | | US | 2004263243 A1 | 30-12-2004 |
| US 7117714 | B2 | 10-10-2006 | CN | 1789919 A | 21-06-2006 |
| | | | JP | 2006174122 A | 29-06-2006 |
| | | | KR | 20060069244 A | 21-06-2006 |
| | | | US | 2006130583 A1 | 22-06-2006 |
| US 5146788 | A | 15-09-1992 | AT | 139337 T | 15-06-1996 |
| | | | AU | 640050 B2 | 12-08-1993 |
| | | | AU | 8550291 A | 30-04-1992 |
| | | | CA | 2053793 A1 | 26-04-1992 |
| | | | DE | 69120203 D1 | 18-07-1996 |
| | | | DE | 69120203 T2 | 30-01-1997 |
| | | | EP | 0482487 A2 | 29-04-1992 |
| | | | ES | 2087946 T3 | 01-08-1996 |
| | | | JP | 2954406 B2 | 27-09-1999 |
| | | | JP | 4265831 A | 22-09-1992 |
| US 5379630 | A | 10-01-1995 | NONE | | |
| US 2005265422 | A1 | 01-12-2005 | CN | 1989404 A | 27-06-2007 |
| | | | EP | 1759188 A2 | 07-03-2007 |
| | | | WO | 2005119232 A2 | 15-12-2005 |

EPO FORM P0459

For more details about this annex : see Official Journal of the European Patent Office, No. 12/82